# EUROPÄISCHE PATENTSCHRIFT

(11) **EP 4 131 384 B1**
(45) Veröffentlichungstag und Bekanntmachung des Hinweises auf die Patenterteilung: **02.12.2026**
(21) Anmeldenummer: 21189014.0
(22) Anmeldetag: 02.08.2021
(51) Int. Cl.: H10F 39/15

(54) **LADUNGSÜBERTRAGUNGSVORRICHTUNG MIT VERENGUNG AM GATTER FÜR TAKTFREQUENZ AB 100 MHZ**
CHARGE TRANSFER DEVICE WITH CONSTRICTION AT THE GATE FOR CLOCK FREQUENCIES ABOVE 100 MHZ
DISPOSITIF DE TRANSFERT DE CHARGE POURVU DE RÉTRÉCISSEMENT SUR LE GRILLAGE POUR LES FRÉQUENCES D'HORLOGE À PARTIR DE 100 MHZ

(43) Veröffentlichungstag der Anmeldung: 08.02.2023
(73) Patentinhaber: Espros Photonics AG, 7320 Sargans (CH)
(72) Erfinder: De Coi, Beat, 7304 Maienfeld (CH); Yu, Chongqi, 7310 Bad Ragaz (CH)
(74) Vertreter: RavensPAT Patentanwälte Partnerschaft mbB

(56) Entgegenhaltungen:
- EP-A2- 0 872 897
- US-A- 4 612 580
- US-A1- 2006 163 620
- US-A1- 2019 253 652

## Beschreibung

Die Erfindung betrifft eine Halbleiterstruktur mit einem Ladungsübertragungskanal für Taktfrequenzen im Bereich ab 100 MHz, vorzugsweise ab 250 MHz, besonders bevorzugt bis 400 MHz.

Bei Taktfrequenzen über 100 MHz, speziell über 250 MHz und besonders bis 400 MHz können vermehrt Verluste beim Transport der Ladungsträger durch einen Ladungsübertragungskanal auftreten. Aus der US 2006/0163620 A1 ist eine CCD-Struktur, bei der sich die Gatter teilweise überlappen, wobei der Kanalbereich hinsichtlich seiner Breite in einer Richtung verringert ist.

Es ist Aufgabe der Erfindung, eine verbesserte Ladungsübertragung bei Taktfrequenzen über 100 MHz, vorzugsweise ab 250 MHz, besonders bevorzugt bis 400 MHz bereitzustellen.

Die Aufgabe wird, ausgehend von einer Halbleiterstruktur der eingangs genannten Art, durch die kennzeichnenden Merkmale des Anspruchs 1 gelöst. Durch die in den Unteransprüchen genannten Maßnahmen sind vorteilhafte Ausführungen und Weiterbildungen der Erfindung möglich.

Die erfindungsgemäße Ladungsübertragungsvorrichtung verwendet unter anderem einen Ladungsträgerkanal. Ein Ladungsübertragungskanal kann eine Überlappung der möglichen elektrostatischen Wirkung von aneinander angrenzenden Gattern mit einer Leitungsschicht in einem Halbleiter sein. Der Ladungsübertragungskanal kann so das Schnittvolumen aus der Projektion der elektrostatischen Wirkung der Gatter auf die Volumenstruktur der Leitungsschicht sein.

Die Leitungsschicht, in welcher der Ladungsträgertransport bzw. die Ladungsträgerübertragung stattfindet, liegt in einem Halbleitersubstrat und kann unterschiedlich zum umgebenden Halbleitersubstrat dotiert sein, sodass sich Ladungsträger in der Leitungsschicht bewegen können und nicht in das umgebende Halbleitersubstrat austreten. Eine Leitungsschicht kann vergraben sein oder an der Oberfläche des Halbleitersubstrats liegen.

Die Gatter können Elektroden sein, welche entlang der Leitungsschicht angeordnet und durch eine dünne, nichtleitende Trennschicht von der Leitungsschicht getrennt sind, sodass sich eine Potentialänderung der Gatter als Änderung des elektrischen Feldes im überlappend zugeordneten Bereich der Leitungsschicht auswirkt. Die Gatter können durch eine dünne Trennschicht isoliert auf dem Halbleitersubstrat liegen.

Ladungsträger können Elektronen oder Löcher sein.

Durch entsprechende Potentialänderungen angrenzender Gatter können Ladungsträger im Ladungsübertragungskanal transportiert werden, sodass der Ladungsübertragungskanal als Leitungskanal für einen gerichteten Fluss von Ladungsträger wirken kann. Die Potentialänderung folgt im Allgemeinen einer Taktfrequenz. Die Potentialänderungen können dabei einer Taktfrequenz folgen. Die Taktfrequenz bestimmt die Geschwindigkeit des Ladungstransports und damit die zeitliche Auflösung und Leistungsfähigkeit umgebender oder angeschlossener Systeme wie etwa Sensoren oder Recheneinheiten.

Grenzen, Form und Verlauf der Gatter, der Leitungsschicht und des Ladungsübertragungskanals sind stets in Draufsicht von den Gattern her in Richtung der Leitungsschicht angegeben, soweit im Einzelfall nicht anders genannt ist. Der Verlauf des Ladungsübertragungskanals und räumliche Relationen sind stets in Richtung des Ladungsträgerflusses im Ladungsübertragungskanal angegeben, soweit im Einzelfall nicht anders genannt ist.

Falls die Breite des Verlaufs der aneinandergereihten Gatter schmaler ist als die Breite des Verlaufs der zugeordneten Leitungsschicht, dann sind die Grenzen der Breite des Verlaufs des Ladungsübertragungskanals durch die Grenzen des Verlaufs der Breite der aneinandergereihten Gatter gegeben. Falls die Breite des Verlaufs der aneinandergereihten Gatter breiter ist als die Breite des Verlaufs der zugeordneten Leitungsschicht, dann sind die Grenzen der Breite des Verlaufs des Ladungsübertragungskanals durch die Grenzen des Verlaufs der Breite der zugeordneten Leitungsschicht gegeben.

Im Zusammenhang mit der Erfindung wurde erkannt, dass bei höheren Taktfrequenzen ab 100 MHz oder 250 MHz oftmals ein Teil der unter einem Gatter befindlichen Ladungsträger bei entsprechender Potentialänderung nicht wie gewünscht zum nächsten Gatter übertritt; in vorteilhafter Weise kann dieser Effekt durch die erfindungsgemäße Ladungsübertragungsvorrichtung reduziert bzw. vermieden werden.

Die erfindungsgemäße Ladungsübertragungsvorrichtung ist eine Ladungsübertragungsvorrichtung entsprechend Anspruch 1.

Dieser erfindungsgemäße Ladungsübertragungskanal kann den Vorteil ausbilden, dass Ladungsträger mit weniger Widerstand und/oder weniger Verlusten fliessen können.

Erfindungsgemäß ist der Bereich der Verengung aus der Mitte des Gatters gegen die Flussrichtung verschoben angeordnet. Es hat sich überraschenderweise herausgestellt, dass durch diese Anordnung die Verluste noch einmal reduziert werden können.

Vorzugsweise ist der Bereich der Verengung mindestens einseitig abgeschrägt ausgeführt.

Erfindungsgemäß ist der Bereich der Verengung trichterförmig ausgeführt.

Erfindungsgemäß nimmt bei gegebener Abnahme des Querschnitts des Leitungskanals im Bereich eines Gatters oder bei gegebener Abnahme des Querschnitts eines Gatters aufgrund der Anordnung der 3 Bereiche der Rücklauf (Spill Back) oder der Flusswiderstand oder der Verlust der Ladungsträger in Flussrichtung ab.

Vorzugsweise ist das Halbleitersubstrat p+ dotiert. Vorzugsweise ist die Leitungsschicht schwach n- dotiert, um den Ladungsträgerfluss zu begünstigen. Vorzugsweise sind die Gatter aus Metall gebildet, um das erzeugte Kraftfeld zu erhöhen. Vorzugsweise ist zwischen den Gattern und der Leitungsschicht eine nichtleitende Schicht angeordnet, wodurch auch der Ladungsträgerverlust reduziert werden kann. Vorzugsweise sind die Gatter untereinander elektrisch isoliert getrennt, um den portionsweisen Transport von Gatter zu Gatter zu begünstigen.

### Überblick über die Zeichnungen:

Ausführungsbeispiele der Erfindung sind in den Zeichnungen dargestellt und werden im Folgenden näher erläutert. Gleiche Bezugszeichen in den einzelnen Figuren bezeichnen dabei einander entsprechende Elemente. Es zeigen:
- Fig. 1: Leitungsübertragungskanal in Seitenansicht entlang Flussrichtung
- Fig. 2: Leitungsübertragungskanal in Seitenansicht senkrecht Flussrichtung

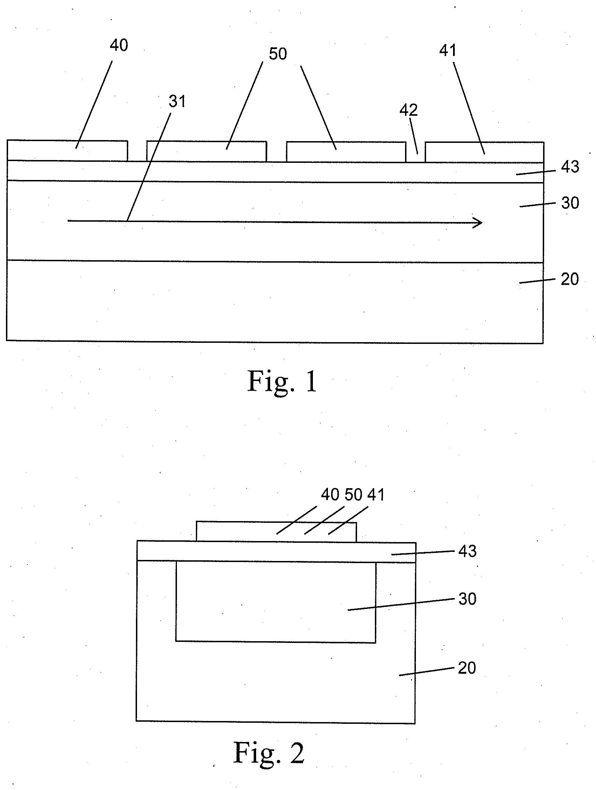

- Fig. 2: Leitungsübertragungskanal mit Verengung in Draufsicht

### Detaillierte Beschreibung der Zeichnungen:

Fig. 1 zeigt einen Ladungsübertragungskanal 10 in Seitenansicht entlang der Flussrichtung 31 der Ladungsträger. Der Aufbau ist analog CCD Technologie. Das umgebende Halbleitersubstrat 20 ist p+ dotiert. Im Halbleitersubstrat 20 ist eine vergrabene Leitungsschicht 30 angeordnet. Die Leitungsschicht ist schwach n-dotiert. Dies hat zur Folge, dass in der Leitungsschicht Elektronen als Ladungsträger frei beweglich sind und nicht in das Halbleitersubstrat eindringen. Auf der Leitungsschicht ist eine Isolationsschicht 43 aufgebracht und darauf sind Gatter 40, 41, 50 aus Metall angeordnet. Die Gatter sind durch Zwischenräume elektrisch voneinander getrennt. Der nicht dargestellte Taktgeber beaufschlagt die benachbarten Gatter wechselweise mit einem positiven Potential in einer Taktfrequenz von 250 MHz, sodass Leitungselektronen in der Leitungsschicht von einem Gatter zum nächsten angezogen und so in Flussrichtung verschoben werden. Die Taktfrequenz könnte auch lediglich über 100 MHz, über 150 MHz oder über 200 MHz betragen. Im Allgemeinen ist die Taktfrequenz nicht höher als 400 MHz. Die Leitungselektronen können beispielsweise photoinduzierte Elektronen aus einem an den Leitungskanal angeschlossenen Bildsensor sein.

Das Halbleitersubstrat 20 ist p+ dotiert und die Leitungsschicht 30 ist n- dotiert. Die Isolationsschicht 43 ist aus SiO2 und die Gatter sind aus Metall gebildet.

Fig. 2 zeigt den Ladungsübertragungskanal in Seitenansicht senkrecht zur Flussrichtung der Ladungsträger. Die Leitungsschicht 30 ist vergraben, sodass im sie von oben und der Seite vom Halbleitersubstrat 20 umfasst ist. Halbleitersubstrat 20 und Leitungsschicht 30 sind nach oben mit einer Isolationsschicht versehen. Die Gatter 40, 41, 50 sind im Bereich über der Leitungsschicht 30 auf der Isolationsschicht 43 angeordnet. Die Gatter sind entlang der Flussrichtung in der Breitenausdehnung schmäler als die Leitungsschicht ausgeführt.

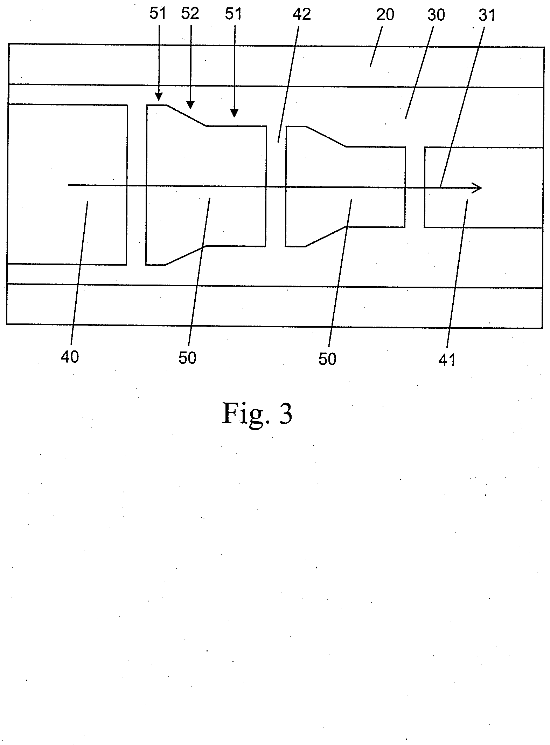

Fig. 3 zeigt den Ladungsübertragungskanal in Draufsicht. Im Halbleitersubstrat 20 ist die Leitungsschicht 30 eingebettet. Die darüber liegende Isolationsschicht ist nicht gezeigt. Über dem Bereich der Leitungsschicht 30, durch die nicht gezeigte Isolationsschicht getrennt, sind die Gatter 40, 50, 41 in Flussrichtung 31 der Elektronen und mit Abständen 42 elektrisch getrennt angeordnet. Insgesamt zeigen die Gatter in Flussrichtung eine Verengung des Querschnitts. Das erste Gatter 40 weist deinen breiten Querschnitt auf, während das letzte Gatter 41 einen vergleichsweise schmäleren Querschnitt aufweist. Die beiden Gatter 50 weisen einen sich in Flussrichtung 31 verengenden Querschnitt auf. Das sich verengende Gatter 50 weist in Flussrichtung 31 zunächst einen breiten Bereich mit konstantem Querschnitt ohne Verengung 51 auf, dann einen im Querschnitt schmäler werdenden Bereich mit Verengung 52 und darauf einen schmäleren Bereich mit wieder konstantem Querschnitt ohne Verengung 51. Das Gatter 50 weist dabei Bereiche mit konstantem Querschnitt am Übergang zu den benachbarten Gattern auf. Der entgegen der Flussrichtung angeordnete Bereich mit konstantem Querschnitt ohne Verengung ist kürzer als der in Flussrichtung angeordnete Bereich mit konstantem Querschnitt ohne Verengung. Dadurch ist der schmäler werdende Bereich mit Verengung 52 aus der Mitte des Gatters 50 entgegen der Richtung der Flussrichtung verschoben angeordnet. Der schmäler werdende Bereich mit Verengung 52 ist beidseitig abgeschrägt ausgeführt, sodass er eine trichterförmige Form aufweist. Durch die so gezeigte Ausführung einer Verengung kann der Rücklauf (Spill Back) und/oder der Flusswiderstand und/oder die Verluste der Ladungsträger in Flussrichtung minimiert werden.

### Bezugszeichenliste:

- 10: Ladungsübertragungskanal

- 20: Halbleitersubstrat

- 30: Leitungsschicht
- 31: Flussrichtung

- 40: Gatter, breit
- 41: Gatter, schmal
- 42: Isolierender Abstand zwischen den Gattern
- 43: Isolationsschicht

- 50: Gatter mit Verengung
- 51: Bereich ohne Verengung
- 52: Bereich mit Verengung

## Patentansprüche

1. Ladungsübertragungsvorrichtung
- mit einem Ladungsübertragungskanal (10) in einem Halbleitersubstrat (20)
- mit einer dotierten Leitungsschicht (30)
- zur beweglichen Aufnahme der Ladungsträger
- mit einer Abfolge von mindestens zwei elektrisch getrennten Gattern (40, 41, 50)
- welche benachbart aufeinander folgen
- zur Verschiebung der Ladungsträger in der Leitungsschicht (30)
- in eine Flussrichtung (31)
- wobei der Ladungsübertragungskanal (10) durch Überlappung der möglichen elektrostatischen Wirkung der Gatter (40, 41, 50) mit der Leitungsschicht (30) ausgebildet ist, und
- mit einem Taktgeber, der dazu geeignet ist,
- eine Taktfrequenz von über 100 MHz, insbesondere von über 150 MHz, über 200 MHz oder ungefähr oder über 250 MHz und insbesondere bis 300 MHz oder 400 MHz auszugeben,
- welcher die Gatter (40, 41, 50) mit Potentialänderungen in Taktfrequenz beaufschlagt,
- zum Transport von Ladungsträgern in der Taktfrequenz von benachbarten Bereichen der Überlappung von benachbarten Gattern (40, 41, 50) mit der Leitungsschicht (30),
wobei
- der Ladungsübertragungskanal (10) im Bereich wenigstens eines der Gatter
- einen Bereich (52) einer Verengung aufweist,
- in welchem der Querschnitt in Flussrichtung (31) abnimmt und kontinuierlich, insbesondere konstant abnimmt, und
- einen Bereich (51) mit konstantem Querschnitt aufweist
- welcher in Flussrichtung (31) vor dem Bereich (52) der Verengung an den Bereich (52) der Verengung unmittelbar angrenzt, und
- einen Bereich (51) mit konstantem Querschnitt aufweist
- welcher in Flussrichtung (31) nach dem Bereich (52) der Verengung an den Bereich (52) der Verengung unmittelbar angrenzt,
wobei
- der Bereich (52) der Verengung trichterförmig ausgeführt ist, sodass bei gegebener Abnahme des Querschnitts des Ladungsübertragungskanals (10) im Bereich des wenigstens einen der Gatter (40, 41, 50) aufgrund der Anordnung der drei Bereiche der Rücklauf (Spill Back) oder der Flusswiderstand oder der Verlust der Ladungsträger in Flussrichtung (31) abnimmt,
**dadurch gekennzeichnet, dass** der Bereich (52) der Verengung aus der Mitte des Gatters (40, 41, 50) gegen die Flussrichtung (31) verschoben angeordnet ist.

2. Ladungsübertragungsvorrichtung nach Anspruch 1,
**dadurch gekennzeichnet, dass**
- der Bereich (52) der Verengung mindestens einseitig abgeschrägt ausgeführt ist.

3. Ladungsübertragungsvorrichtung nach einem der vorhergehenden Ansprüche,
**dadurch gekennzeichnet, dass**
- das Halbleitersubstrat (20) p+ dotiert ist und/oder
- die Leitungsschicht (30) schwach n- dotiert ist und/oder
- die Gatter (40, 41, 50) aus Metall gebildet sind und/oder
- zwischen den Gattern (40, 41, 50) und der Leitungsschicht (30) eine nichtleitende Schicht (43) angeordnet ist und/oder
- die Gatter (40, 41, 50) untereinander elektrisch isoliert getrennt sind.

## Claims

1. Charge transfer device
- having a charge transfer channel (10) in a semiconductor substrate (20)
- having a doped conduction layer (30)
- for movably accepting the charge carriers,
- having a sequence of at least two electrically isolated gates (40, 41, 50)
- which adjacently succeed one another
- for transferring the charge carriers in the conduction layer (30)
- in a flow direction (31),
- wherein the charge transfer channel (10) is formed by overlap of the possible electrostatic effect of the gates (40, 41, 50) with the conduction layer (30), and
- having a clock generator suitable for outputting
- a clock frequency of more than 100 MHz, in particular of more than 150 MHz, more than 200 MHz or approximately or more than 250 MHz and in particular up to 300 MHz or 400 MHz,
- which clock generator applies changes in potential at the clock frequency to the gates (40, 41, 50),
- for transporting charge carriers at the clock frequency from adjacent regions of the overlap between adjacent gates (40, 41, 50) and the conduction layer (30),
wherein
- the charge transfer channel (10) in the region of at least one of the gates
- has a region (52) of a constriction
- in which the cross section in the flow direction (31) decreases, and decreases continuously, in particular in a constant fashion, and
- has a region (51) with a constant cross section
- which directly adjoins the region (52) of the constriction upstream of the region (52) of the constriction in the flow direction (31), and
- has a region (51) with a constant cross section
- which directly adjoins the region (52) of the constriction downstream of the region (52) of the constriction in the flow direction (31),
wherein
- the region (52) of the constriction is embodied as funnel-shaped, such that for a given decrease in the cross section of the charge transfer channel (10) in the region of the at least one of the gates (40, 41, 50) on account of the arrangement of the three regions, the spillback or the flow resistance or the loss of the charge carriers in the flow direction (31) decreases,
**characterized in that** the region (52) of the constriction is arranged in a manner displaced from the centre of the gate (40, 41, 50) counter to the flow direction (31).

2. Charge transfer device according to Claim 1,
**characterized in that**
- the region (52) of the constriction is embodied as bevelled at least on one side.

3. Charge transfer device according to either of the preceding claims,
**characterized in that**
- the semiconductor substrate (20) is p+ doped and/or
- the conduction layer (30) is weakly n- doped and/or
- the gates (40, 41, 50) are formed from metal and/or
- a non-conducting layer (43) is arranged between the gates (40, 41, 50) and the conduction layer (30) and/or
- the gates (40, 41, 50) are separated in a manner electrically insulated from one another.

## Revendications

1. Dispositif de transfert de charge
- comprenant un canal de transfert de charge (10) dans un substrat en semiconducteur (20)
- comprenant une couche conductrice dopée (30)
- destinée à recevoir les porteurs de charge de manière mobile
- comprenant une succession d'au moins deux grilles (40, 41, 50) électriquement isolées
- lesquelles se suivent en étant voisines les unes des autres
- destinées à décaler les porteurs de charge dans la couche conductrice (30)
- dans une direction de flux (31)
- le canal de transfert de charge (10) étant réalisé par le chevauchement de l'effet électrostatique possible des grilles (40, 41, 50) avec la couche conductrice (30) et
- comprenant un générateur d'horloge, qui est adapté pour
- délivrer une fréquence d'horloge de plus de 100 MHz, de préférence de plus de 150 MHz, de plus de 200 MHz ou approximativement de ou de plus de 250 MHz notamment jusqu'à 300 MHz ou 400 MHz,
- laquelle soumet les grilles (40, 41, 50) à des changements de potentiel à la fréquence d'horloge
- destiné au transport de porteurs de charge à la fréquence d'horloge de zones voisines du chevauchement de grilles (40, 41, 50) voisines avec la couche conductrice (30),
- le canal de transfert de charge (10), dans la zone d'au moins l'une des grilles,
- présentant une zone (52) d'un rétrécissement
- dans laquelle la section transversale diminue dans la direction de flux (31), et diminue de manière continue, notamment de manière constante et
- présentant une zone (51) à constante section transversale
- laquelle, dans le sens du flux (31), se trouve en amont de la zone (52) du rétrécissement et est directement adjacente à la zone (52) du rétrécissement et
- présentant une zone (51) à constante section transversale
- laquelle, dans le sens du flux (31), se trouve en aval de la zone (52) du rétrécissement et est directement adjacente à la zone (52) du rétrécissement,
- la zone (52) du rétrécissement étant réalisée en forme d'entonnoir, de sorte que, avec une diminution donnée de la section transversale du canal de transfert de charge (10), le reflux (Spill Back) ou la résistance au flux ou la perte des porteurs de charge diminue dans le sens du flux (31) dans la zone de l'au moins une des grilles (40, 41, 50) en raison de la disposition des trois zones,
**caractérisé en ce que** la zone (52) du rétrécissement est disposée décalée du centre de la grille (40, 41, 50) à l'opposé du sens du flux (31).

2. Dispositif de transfert de charge selon la revendication 1,
**caractérisé en ce que**
- la zone (52) du rétrécissement est réalisée chanfreinée au moins d'un côté.

3. Dispositif de transfert de charge selon l'une des revendications précédentes,
**caractérisé en ce que**
- le substrat en semiconducteur (20) est dopé p+ et/ou
- la couche conductrice (30) est faiblement dopée n-et/ou
- les grilles (40, 41, 50) sont constituées de métal et/ou
- une couche non conductrice (43) est disposée entre les grilles (40, 41, 50) et la couche conductrice (30) et/ou
- les grilles (40, 41, 50) sont séparées en étant électriquement isolées les unes des autres.
